# EUROPEAN PATENT APPLICATION

(11) **EP 0 620 585 A1**
(43) Date of publication of application: **19.10.1994**
(21) Application number: 94103890.3
(22) Date of filing: 14.03.1994
(51) Int. Cl.: H01L 21/3105, H01L 21/311, H01L 21/00

(54) **Apparatus and method for flattening an insulating layer by etching in a semiconductor device**

(30) Priority: 14.04.1993 JP 87466/93
(71) Applicant: KABUSHIKI KAISHA TOSHIBA, Kawasaki-shi, Kanagawa-ken 210 (JP)
(72) Inventor: Mase, Yasukazu, Intell. Property Division, Minato-ku, Tokyo 105 (JP); Abe, Masahiro, Intell. Property Division, Minato-ku, Tokyo 105 (JP); Tomita, Ken-ichi, Intell. Property Division, Minato-ku, Tokyo 105 (JP); Yahiro, Kazuyuki, Intell. Property Division, Minato-ku, Tokyo 105 (JP); Ishiguro, Akira, Intell. Property Division, Minato-ku, Tokyo 105 (JP)
(74) Representative: Blumbach, Kramer & Partner

(57) **Abstract**

An ice layer (26) of an etchant is formed on the upper surface of a surface table (25) by a cooling mechanism (25b), and is kept at a temperature near the freezing point of the etchant. Thereafter, a semiconductor substrate (20) having an insulating layer formed on one surface thereof is fixed on the lower surface of a chuck mechanism (24) such that the other surface of the substrate (20) is in contact with the lower surface. The insulating layer is pressed against the ice layer (26) with a predetermined load. Then, the chuck mechanism (24) is rotated by a second motor in a first direction (27), together with a second shaft (24a), while the surface table (25) is rotated by a first motor in a second direction (28), together with a first shaft (25a). At the same time, the chuck mechanism (24) is slid on the surface table (25), thereby selectively etching the insulating layer.

## Description

This invention relates to an apparatus and a method for manufacturing a semiconductor device, which are used, in particular, to flatten an insulating layer.

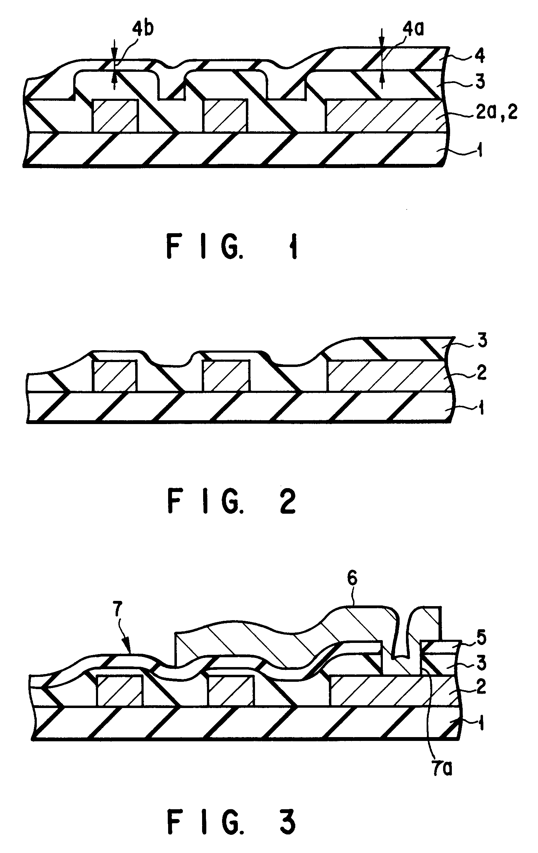

FIGS. 1 - 3 are cross sectional view, useful in explaining a conventional method for manufacturing a semiconductor device. First, an insulating layer 1 on a silicon substrate (not shown), and then an Aℓ-Si-Cu wiring layer 2a of a thickness of 1.0 µm is deposited on the lowermost insulating layer 1 by sputtering. The wiring layer 2a is patterned by photolithography, thereby forming a lower wire 2 on the insulating layer 1. Thereafter, a first SiO₂ insulating layer 3 of a thickness of 1 µm is formed on the lower wire 2 and the insulating layer 1 by the use of CVD (Chemical Vapor Deposition). The insulating layer 3 is coated with a resist layer 4 having a thickness of 0.6 µm by a rotational coating method.

Then, as is shown in FIG. 2, a resist etchback method is used to flatten the first insulating layer 3. Specifically, the resist layer 4 and the first insulating layer 3 are etched back by a RIE (Reactive Ion Etching) method, using an etching ratio of 1.2 : 1.0. As a result, the resist layer 4 is etched back by a thickness of 0.6 µm, and the first insulating layer 3 is etched back by a thickness of 0.4 µm.

As is shown in FIG. 3, a second SiO₂ insulating layer 5 of a thickness of 0.4 µm is formed on the first insulating layer 3 by the CVD. Thus, an interlayer insulating film consisting of first and second insulating layers 3 and 5 is provided on the insulating layer 1 and the lower wire 2. Subsequently, a via hole 7a is formed in that portion of the interlayer insulating film 7 which is located on the lower wire 2 by the use of the photolithography and RIE methods. An Aℓ-Si upper wire 6 having a thickness of 1.0 µm and a predetermined pattern is provided in the via hole 71 and on the interlayer insulating film 7, thus completing two-layered wiring.

Since in the above-described conventional method, the resist layer 4 is coated with the first insulating layer 3 by means of the rotational coating method; the thickness 4a of that portion of the resist layer 4, which is deposited on a wider portion of the wire 2, is inevitably greater than the thickness 4b of that portion of the resist layer 4, which is deposited on a narrower portion of the wire 2. Specifically, in the case of the above-described semiconductor device, the thickness 4a of the resist layer 4 deposited on that portion of the wire 2 which has a width of 20 µm or more, is 0.6 µm. On the other hand, the thickness 4b of the resist layer 4 deposited on that portion of the wire 2, which has a width of about 2 µm and is separated by about 10 µm from an adjacent portion of the wire 2, is 0.1 µm. The difference in thickness between those portions of the resist layer 4 is 0.5 µm. Accordingly, where the first insulating layer 3 is flattened by the resist etchback method, the difference in thickness between the above-described portions of the resist layer 4 corresponds to the difference in thickness between the portions of the first insulating layer 3 which correspond to the first-mentioned portions and are obtained after the flattening process. Thus, that portion of the interlayer insulating film 7 which is located on a narrower portion of the lower wire 2 is thinner than that portion of the layer 7 which is located on a wider portion of the wire 2. As a result, interlayer leakage of electricity may occur at the thinner portion of the interlayer insulating film 7, or the breakdown voltage of the layer 7 may be reduced because of the thinner portion.

Increasing the thickness of the interlayer insulating film 7, for example, by increasing the thickness of the second insulating layer 5 can overcome the above disadvantages.

However, increasing the thickness of the second insulating layer 5 excessively increases the thickness of that portion of the interlayer insulating film 7 which is located on the wider portion of the lower wire 2. Accordingly, the depth of the via hole 7a formed on the thick portion of the layer 7 is inevitably increased, and therefore the via hole 7a may not sufficiently be coated with the upper wire 6, resulting in conduction failure at the via hole.

Further, in the case where via holes are formed in a thick portion and a thin portion of the interlayer insulating film 7, that one of the via hole which is formed in the thin portion is excessively etched since the etching time is determined on the basis of the thick portion. Hence, the thinner portion of the lower wire 2 which is in contact with the via hole is etched by sputtering. As a result, a residue which is hard to be removed may be created in the vicinity of the via hole. This residue may cause corrosion in the via hole.

It is the object of the invention to provide an apparatus for manufacturing a semiconductor device, capable of flattening an insulating layer on a wiring layer above a semiconductor substrate, and of making uniform the thickness of the insulating layer on the wiring layer; and a method for manufacturing the semiconductor device.

According to an aspect of the invention, there is provided an apparatus for manufacturing a semiconductor device, comprising:
a rotatable table having an upper surface on which an etchant is to be placed;
a cooling mechanism connected to the table for freezing the etchant; and
a rotatable fixing member provided above the table for fixing a semiconductor substrate having a layer, the fixing member being slidable over the upper surface of the table.

According to another aspect of the invention, there is provided a method for manufacturing a semiconductor device, comprising the steps of:
forming a wiring layer above a semiconductor substrate;
forming an insulating layer on the wiring layer; and
sliding the insulating layer on an ice layer of the etchant, thereby forming liquidized layers of the etchant at contact portions between the insulating layer and the ice layer, and etching the contact portions of the insulating layer with the use of the liquidized layers.

This invention can be more fully understood from the following detailed description when taken in conjunction with the accompanying drawings, in which:
FIG. 1 is a cross sectional view, showing a process employed in a method for manufacturing a conventional semiconductor device;
FIG. 2 is a cross sectional view, showing that process employed in the method which follows the process shown in FIG. 1;
FIG. 3 is a cross sectional view, showing that process employed in the method which follows the process shown in FIG. 2;
FIG. 4 is a perspective view, showing an essential part of an apparatus for manufacturing semiconductor devices according to first and second embodiments of the invention;
FIG. 5 is a cross sectional view, showing a process employed in a method for manufacturing the semiconductor device according to the first embodiment of the invention;
FIG. 6 is a cross sectional view, showing that process employed in the method according to the first embodiment which follows the process shown in FIG. 5;
FIG. 7 is a cross sectional view, showing that process employed in the method according to the first embodiment which follows the process shown in FIG. 6;
FIG. 8 is a cross sectional view, showing that process employed in the method according to the first embodiment which follows the process shown in FIG. 7;
FIG. 9 is a cross sectional view, showing a process employed in a method for manufacturing a semiconductor device according to the second embodiment of the invention;
FIG. 10 is a cross sectional view, showing that process employed in the method according to the second embodiment which follows the process shown in FIG. 9;
FIG. 11 is a cross sectional view, showing that process employed in the method according to the second embodiment which follows the process shown in FIG. 10;
FIG. 12 is a cross sectional view, showing that process employed in the method according to the second embodiment which follows the process shown in FIG. 11; and
FIG. 13 is a cross sectional view, showing that process employed in the method according to the second embodiment which follows the process shown in FIG. 12.

The embodiments of the invention will be explained in detail with reference to the accompanying drawings.

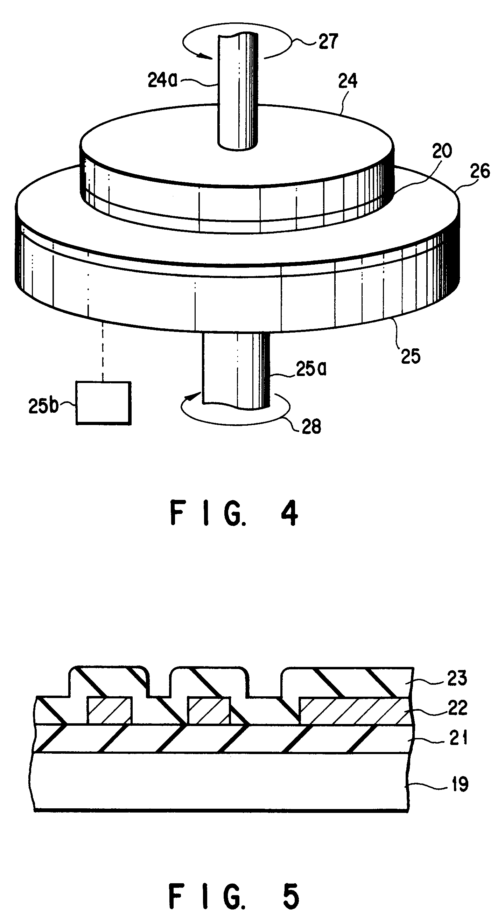

FIG. 4 is a perspective view, showing an essential part of an apparatus for manufacturing semiconductor devices according to first and second embodiments of the invention. As is shown in FIG. 4, a first shaft 25a is provided on the lower surface of a surface table 25 having a cooling mechanism 25b, and is connected to a first motor (not shown) for rotating the shaft 25a. A chuck mechanism 24 is provided above the surface table 25 for fixing a semiconductor substrate 20. A second shaft 24a is provided on the chuck mechanism 24, and connected to a second motor (not shown) for rotating the shaft 24a.

An ice layer 26 of an etchant is formed by the cooling mechanism 25b on the upper surface of the surface table 25. The ice layer 26 contains, for example, 10% hydrofluoric acid by volume, and is kept at a temperature in the vicinity of the freezing point of the etchant. The semiconductor substrate 20 is brought into tight contact with the lower surface of the chuck mechanism 24. Thereafter, the lower surface of the mechanism 24 is pressed against the upper surface of the surface table 25 with a predetermined load, and then the mechanism 24 is rotated by the second motor in a first direction indicated by arrow 27, together with the second shaft 24a connected to the motor. At the same time, the surface table 25 is rotated by the first motor in a second direction indicated by arrow 28, together with the first shaft 25a. Thus, the chuck mechanism 24 slides on the upper surface of the surface table 25.

FIGS. 5 - 8 are sectional views, useful in explaining a method for manufacturing the semiconductor device according to the first embodiment, with the use of the manufacturing apparatus shown in FIG. 4. First, a first insulating layer 21 is provided on a silicon substrate 19. Then, a lower wiring layer 22 made of Aℓ-Si-Cu and having a thickness of about 1.0 µm and a predetermined pattern is formed on the first insulating layer 21 by the use of the sputtering method, the photolithography method or the RIE method. Thereafter, a second insulating layer 23 made of SiO₂ and having a thickness of about 1.0 µm is formed by the plasma CVD method on the lower wiring layer 22 and the first insulating layer 21.

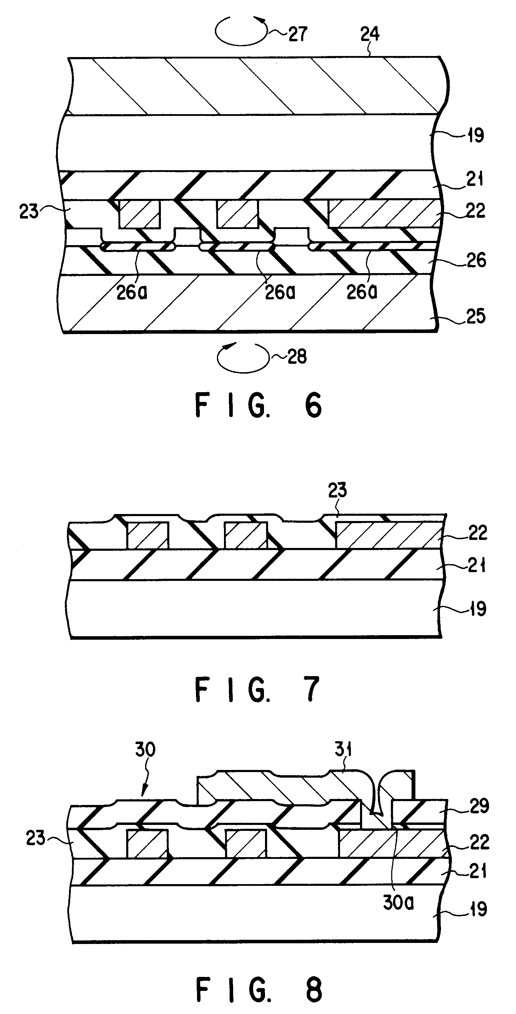

Then, as is shown in FIG. 6, the resultant silicon substrate 19 is fixed onto the chuck mechanism 24 shown in FIG. 4, and pressed against the surface table 25 with a load, for example, of about 0.8 kg/cm². Thus, the second insulating layer 23 is pressed against the ice layer 26 formed on the table 25 and containing 10% by volume of hydrofluoric acid. In this state, the chuck mechanism 24 is rotated, for example, at 30 rpm in the first direction indicated by arrow 27, while the surface table 25 is rotated, for example, at 10 rpm in the second direction indicated by arrow 28 and opposite to the first direction. As a result, liquidized layers 26a are formed at contact portions between the second insulating layer 23 and the ice layer 26. The liquidized layers 26a selectively etch the second insulating layer 23. In other words, only those portions of the second insulating layer 23 which contact the liquidized layers 26a are etched.

Subsequently, as is shown in FIG. 7, when the thickness of those portions of the second insulating layer 23 which are formed on the lower wiring layer 22 have reached about 0.2 µm, the chuck mechanism 24 and the surface table 25 stop their rotation, and the load applied to the mechanism 24 is released therefrom, thereby finishing the etching. Then, the silicon substrate 19 is dismounted from the chuck mechanism 24, and the second insulating layer 23 is subjected to an after-treatment such as brush scrubbing, where the layer 23 is flattened.

Thereafter, as is shown in FIG. 8, a third insulating layer 29 made of SiO₂ and having a thickness of about 0.8 µm is formed on the second insulating layer 23 by means of the plasma CVD method. Thus, a flat interlayer insulating layer 30 consisting of the second and third insulating layers 23 and 29 is provided on the first insulating layer 21 and the lower wiring layer 22. Subsequently, a via hole 30a is formed in that portion of the interlayer insulating layer 30 which is formed on the lower wiring layer 22 by means of the photolithography and the RIE method. An upper wiring layer 31 made of Aℓ-Si-Cu and having a thickness of about 1.0 µm and a predetermined pattern is formed in the via hole 30a and on the interlayer insulating layer 30 by means of the sputtering method, the photolithography method and the RIE method. Thus, a two-layered wiring structure comprising the lower and upper wiring layers 22 and 31 has been completed.

In the above-described first embodiment, the liquidized layers 26a are formed at contact portions between the second insulating layer 23 and the ice layer 26 for etching and flattening the second insulating layer 23. As a result, the flat third insulating layer 29 can be obtained. This means that the interlayer insulating layer 30 can have a flat surface.

Further, that portion of the upper insulating layer 30 which is formed on a narrow portion of the lower wiring layer 22 can have substantially the same thickness as that portion of the layer 30 which is formed on a wide portion of the layer 22. Accordingly, leakage of electricity from the interlayer insulating layer 30 and reduction of the breakdown voltage of the layer 30 can be prevented, thereby increasing the yield of semiconductor devices and the reliability thereof.

Moreover, since the second insulating layer 23 on the lower wiring layer 22 does not have a thin portion, it is not necessary to increase the thickness of the third insulating layer 29 formed on the second insulating layer 23. As a result, the via hole 30a can sufficiently be covered by the upper wiring layer 31. This can prevent conduction failure in the via hole, and hence can enhance the yield and the reliability of semiconductor devices.

Furthermore, the lower wiring layer can be prevented from being excessively etched at the time of etching performed to form the via hole in the interlayer insulating layer, as in the conventional case. Accordingly, residues which are hard to remove can be prevented from being created in the vicinity of the via hole, and hence corrosion due to such residues can be prevented.

Although in the first embodiment, the Aℓ-Si-Cu lower wiring layer 22 having a thickness of 1.0 µm is formed on the first insulating layer 21, the lower wiring layer may be made of another material such as a polysilicon or a high-fusing-point metal, and may have a thickness differing from the above.

In addition, although the Aℓ-Si-Cu upper wiring layer 31 having a thickness of 1.0 µm is formed in the via hole 30a and on the interlayer insulating layer 30, the upper wiring layer may be made of another material such as a polysilicon or a high-fusing-point metal, and may have a thickness differing from the above.

Yet further, although the second SiO₂ insulating layer 21 having a thickness of 1.0 µm is formed on the lower wiring layer 22 and the first insulating layer 21 by means of the plasma CVD method, the second insulating layer may be made of another insulating material, have another thickness, and be formed by another method.

Although the third SiO₂ insulating layer 29 having a thickness of 0.8 µm is formed on the second insulating layer 23 by means of the plasma CVD method, the third layer 29 may be made of another insulating material, have another thickness, and be formed by another method.

Although the ice layer 26 of an etchant containing 10% hydrofluoric acid by volume is formed on the upper surface of the surface table 25, the ice layer may be made of another etchant, and an etching stabilizer may be added into the etchant.

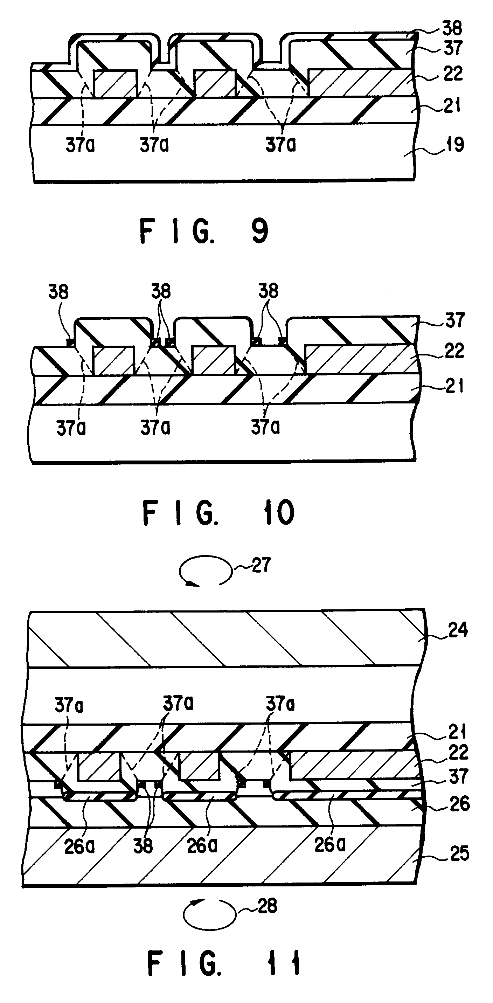

FIGS. 9 - 13 are sectional views, useful in explaining a method for manufacturing a semiconductor device according to a second embodiment, with the use of the manufacturing apparatus shown in FIG. 4. Elements similar to those employed in the first embodiment are denoted by corresponding reference numerals, and explanations will be given only of different elements.

A second insulating layer 37 made of SiO₂ and having a thickness of e.g. 1.0 µm is formed on the lower wiring layer 22 and the first insulating layer 21 by means of the CVD method. At this time, weak portions 37a in the second insulating layer 37 are formed in the vicinity of side portions of the lower wiring layer 22. Thereafter, polysilicon layers 38 having a thickness of about 0.2 µm and serving as etching masks are formed on the second insulating layer 37 by means of the CVD method, at a temperature, for example, of about 640°C.

Then, as is shown in FIG. 10, the polysilicon layers 38 are etched back by means of the RIE method, with the result that polysilicon layers 38 having a thickness of about 0.2 µm remain along the bottom edges of concave portions of the second insulating layer 37. These polysilicon layers 38 serve as etching masks for protecting the weak portions 37a of the second insulating layer 37.

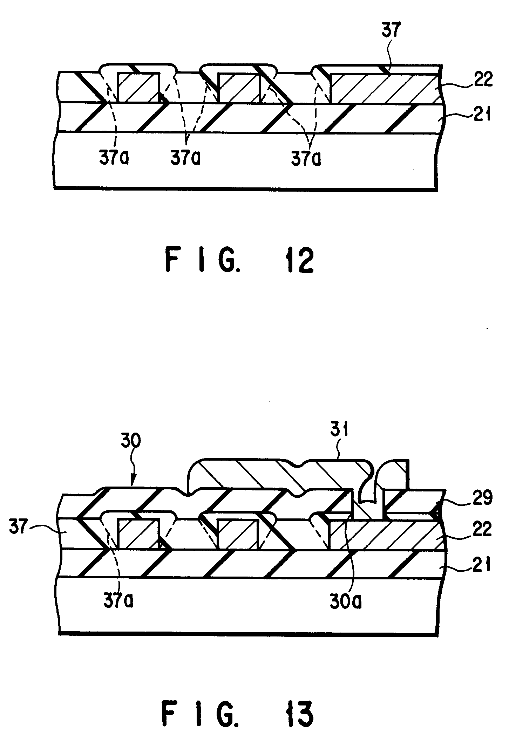

Thereafter, as is shown in FIG. 11, the liquidized layers 26a are formed at contact portions between the ice layer 26 and the second insulating layer 37, for selectively etching the second insulating layer 37.

As is shown in FIG. 12, after completing the etching of the second insulating layer 37, the polysilicon layers 38 as the etching masks are removed by CDE (Chemical Dry Etching). Then, the layer 37 is subjected to an after-treatment such as brush scrubbing, with the result that the layer 37 is flattened.

Thereafter, as is shown in FIG. 13, a flat interlayer insulating layer 30 consisting of the second insulating layer 37 and a third insulating layer 29 is formed on the first insulating layer 21 and the lower wiring layer 22. Then, a via hole 30a is formed in the interlayer insulating layer 30, and an upper wiring layer 31 is formed in the via hole 30a and on the layer 30, thus providing a two-layered wiring structure comprising the lower and upper wiring layers 22 and 31.

The above-described second embodiment can provide an effect similar to that of the first embodiment.

Further, since in the second embodiment the weak portions 37a which can easily be etched are protected by the polysilicon layers 38 serving as etching masks, the weak portions 37a are prevented from being excessively etched at the time of etching the second insulating layer 37 to flatten the same. Accordingly, conduction failure due to leakage of electricity in the interlayer insulating layer or due to breakage of the lower wiring layer 22 can be prevented, and hence the yield of production be enhanced.

Although in the second embodiment, etching masks, i.e., the polysilicon layers 38, are provided to protect the weak portions 37a formed in the vicinity of side portions of the second insulating layer 37, these etching masks may be made of another material such as plasma SiN or a resist.

Further, although the polysilicon layers 38 as the etching masks are removed by the CDE method, the removal may be done by other methods.

Moreover, although after etching the second insulating layer 37, the polysilicon layers 38 are removed by the CDE method, thereby performing an after-treatment such as brush scrubbing; the after-treatment may be performed immediately after etching the same, i.e., without removing the polysilicon layer 38.

## Claims

1. An apparatus for manufacturing a semiconductor device, characterized by comprising:
a rotatable table (25) having an upper surface on which an etchant (26) is to be placed;
a cooling mechanism (25b) connected to the table (25) for freezing the etchant (26); and
a rotatable fixing member (24) provided above the table (25) for fixing a semiconductor substrate (20) having a layer, the fixing member (24) being slidable over the upper surface of the table (25).

2. The apparatus according to claim 1, characterized in that the etchant (26) contains an HF-based material as a main component.

3. A method for manufacturing a semiconductor device, characterized by comprising the steps of:
forming a wiring layer (22) above a semiconductor substrate (19);
forming an insulating layer (23) on the wiring layer (22); and
sliding the insulating layer (23) on an ice layer (26) of the etchant, thereby forming liquidized layers (26a) of the etchant at contact portions between the insulating layer (23) and the ice layer (26), and etching the contact portions of the insulating layer (23) with the use of the liquidized layers (26a).

4. The method according to claim 3, characterized in that the etchant (26) contains an HF-based material as a main component.

5. A method for manufacturing a semiconductor device, characterized by comprising the steps of:
forming a wiring layer (22) above a semiconductor substrate (19);
forming an insulating layer (37) on the wiring layer (22);
forming protection masks (38) on the bottom edges of concave portions of the insulating layer (37); and
sliding the insulating layer (37) on an ice layer (26) of the etchant, thereby forming liquidized layers (26a) of the etchant at contact portions between the insulating layer (37) and the ice layer (26), and etching the contact portions of the insulating layer (37) with the use of the liquidized layers (26a).

6. The method according to claim 5, characterized in that the etchant (26) contains an HF-based material as a main component.

7. The method according to claim 5, characterized in that the protection masks (38) consist of polysilicon layers.
